(19) **Europäisches Patentamt**

**European Patent Office**

**Office européen des brevets**

(11) **EP 1 085 518 B1**

(12) **FASCICULE DE BREVET EUROPEEN**

| | |
|---|---|
| (45) Date de publication et mention de la délivrance du brevet:<br>**10.04.2002 Bulletin 2002/15** | (51) Int Cl.$^7$: **G11C 16/02**, H01L 27/115,<br>G11C 16/04 |

(21) Numéro de dépôt: **00402548.2**

(22) Date de dépôt: **15.09.2000**

(54) **Architecture d'une mémoire non volatile électriquement programmable et effacable**

Elektrisch programmier- und löschbare Festwertspeicherarchitektur

Electrically programmable and erasable non-volatile memory architecture

(84) Etats contractants désignés:
**FR GB**

(72) Inventeur: **Naura, David**
**94230 Cachan (FR)**

(74) Mandataire: **Ballot, Paul**
**Cabinet Ballot**
**122, rue Edouard Vaillant**
**92593 Levallois Perret Cedex (FR)**

(30) Priorité: **16.09.1999 FR 9911600**

(43) Date de publication de la demande:
**21.03.2001 Bulletin 2001/12**

(73) Titulaire: **STMicroelectronics S.A.**
**92120 Montrouge (FR)**

(56) Documents cités:
**EP-A- 0 801 398**

**Description**

La présente invention concerne une architecture d'une mémoire non volatile électriquement programmable et effaçable, notamment d'une mémoire EEPROM ou flash EPROM.

Les mémoires EEPROM sont des mémoires bien connues de l'homme du métier. Chaque cellule est constituée en pratique d'au moins un transistor à grille flottante et un transistor d'accès.

Selon l'architecture habituelle, matricielle, des mémoires, chaque cellule est commandée par une ligne de bit et une ligne de mot de la mémoire. Les lignes de mot et lignes de bit sont pilotées par les sorties du circuit de décodage d'adresse de la mémoire. Chaque cellule peut ainsi être lue ou écrite individuellement, par sélection de la ligne de bit et de la ligne de mot correspondantes.

Mais il est aussi habituel de prévoir un accès par mot à la mémoire. En effet nombre de données dans des applications ne sont pas codées que sur un seul bit, mais sur plusieurs. Les architectures mémoires courantes prévoient ainsi la possibilité d'accéder simultanément à plusieurs bits, typiquement 8, 16 ou 32. Dans tous les cas, l'unité de base en termes de mot mémoire est l'octet, formé de huit bits. Toutes les architectures mémoires sont basées sur l'octet.

En pratique, les huit bits d'un octet sont situés sur la même ligne de mot. Dans le cas d'une mémoire dite 16 bits, le plan mémoire est généralement divisé en deux, un mot de 16 bits étant formé d'un octet dans un demi-plan et d'un autre octet dans l'autre demi-plan.

Du fait des grandes capacités mémoire recherchées, une ligne de mot permet l'accès à plusieurs octets. Par exemple, on peut avoir 128 lignes de bit pour 128 lignes de mot. Chaque ligne de mot contient alors 16 octets.

Pour permettre la sélection simultanée de tous les bits d'un mot d'une ligne de mot, et seulement de ceux-là, on prévoit un groupement des mots de la mémoire en colonnes, la colonne de rang i étant celle qui comprend le mot de même rang dans chaque ligne de mot. Une telle architecture nécessite des transistors d'accès supplémentaires permettant chacun la sélection d'une colonne particulière de la mémoire. Diverses possibilités d'architectures s'offrent au concepteur, selon les spécifications concernant les accès à la mémoire.

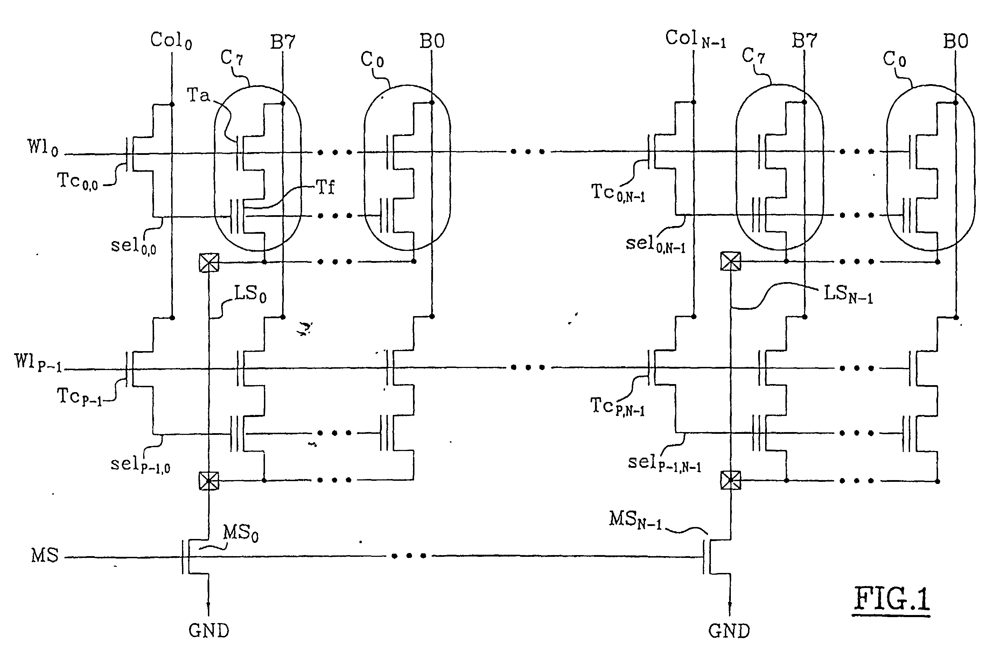

Un exemple d'une telle architecture mémoire organisée en colonne de mots de n cellules mémoire est représenté sur la figure 1. Dans cette architecture, on a prévu un transistor d'accès supplémentaire par mot de la mémoire. Si la mémoire comprend p lignes de mot et N colonnes, on a ainsi p transistors d'accès par colonne, un par ligne de mot, soit un total de pxN transistors d'accès supplémentaires, un par mot. Ces transistors d'accès supplémentaires reçoivent un signal de sélection de la ligne de mot associée ainsi qu'un signal de sélection de la colonne associée, ces signaux étant fournis par le circuit de décodage d'adresse de la mémoire.

Sur la figure 1, on a ainsi représenté une mémoire organisée en colonnes de mot de n=8 cellules mémoire $C_0$ à $C_7$, comprenant p lignes de mot $Wl_0$ à $Wl_{p-1}$ et N colonnes $Col_0$ à $Col_{N-1}$. Chaque colonne comprend huit lignes de bit B0 à B7, chacune connectée aux cellules de même rang des mots de la colonne.

Chaque cellule mémoire comprend un transistor d'accès Ta en série avec un transistor à grille flottante Tf. Le transistor d'accès est connecté sur sa grille à la ligne de mot correspondante et sur son drain, à la ligne de bit correspondante. Un transistor d'accès supplémentaire de colonne est prévu par mot. Ce transistor d'accès de colonne, par exemple $Tc_{0,0}$, est connecté sur sa grille à la ligne de mot correspondante, $Wl_0$, et sur son drain à la ligne de sélection de colonne correspondante, $Col_0$. Il transmet sur sa source un signal de sélection de mot, $Sel_{0,0}$, appliqué sur la grille de contrôle des transistors à grille flottante des cellules $C_0$ à $C_7$ du mot considéré.

Les architectures habituelles de mémoire EEPROM comprennent des lignes de source pour tirer les sources des cellules mémoire à la masse, pour la lecture notamment. Dans le cas d'une architecture de mémoire à accès par mot, on prévoit une ligne de source par colonne. On a ainsi la ligne de source $LS_0$ pour la colonne $Col_0$, qui permet de relier les sources des transistors à grille flottante des cellules mémoire de cette colonne, à un transistor correspondant de mise à la masse $MS_0$.

Si on reprend la figure 1, on a ainsi N lignes de source $LS_0$ à $LS_{N-1}$ et N transistors de mise à la masse, $MS_0$ à $MS_{N-1}$, un par colonne. Le nombre de ces transistors dépend typiquement de l'architecture mémoire retenue par le concepteur, selon les contraintes d'application d'une part et des règles de conception et dessin d'autres part. Il est ainsi possible d'avoir un unique transistor de mise à la masse pour tout le plan mémoire, pourvu qu'il puisse passer tout le courant nécessaire dans les différents modes d'accès à la mémoire.

Le problème qui se pose avec les architectures mémoire à accès par mot, réside dans la connexion des sources des transistors à grille flottante des cellules mémoire à un transistor de mise à la masse qui se situe en dehors du plan mémoire. Les sources des cellules mémoire sont des diffusions. La réalisation de la connexion de ces diffusions à un transistor de mise à la masse doit tenir compte des contraintes d'implémentation liées à la technologie, et se faire en utilisant le moins d'espace d'implémentation possible (lay-out). Le but recherché est d'obtenir un produit fini de petites dimensions à moindre coût. En pratique, on utilise une ligne de source en métal par colonne, pour connecter la diffusion des sources des cellules mémoire au transistor de mise à la masse. Cette ligne de source doit être située en dehors des zones d'implémentation des cellules mémoire, pour ne pas rajouter un niveau de couche de métal supplémentaire dans le circuit intégré.

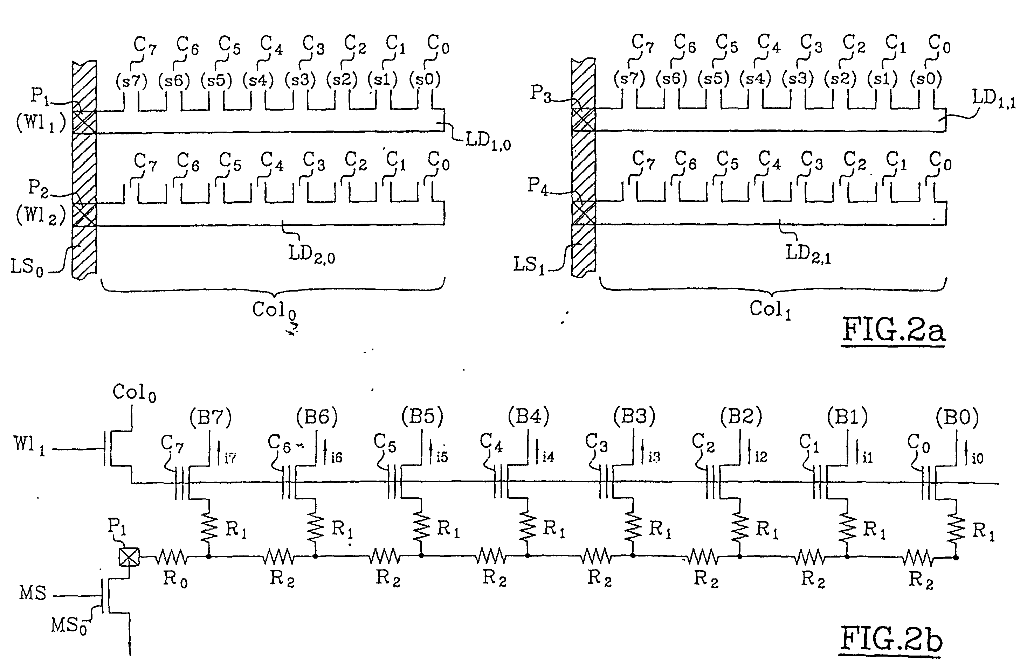

Sur la figure 2a, on a ainsi représenté l'implémentation partielle des deux premiers mots de deux lignes de mots consécutives $WI_1$ et $WI_2$. Cette implémentation montre la réalisation d'une zone de diffusion pour chaque mot.

Dans la première colonne $Col_0$ de la mémoire, on a ainsi la zone de diffusion $LD_{1,0}$ qui forme la source $S_0,...$ $S_7$ de chacun des transistors à grille flottante des cellules mémoire $C_0$ à $C_7$ du premier mot de la ligne de mot $WI_1$ et la zone de diffusion $LD_{2,0}$ qui forme la source $S_0,....$ $S_7$ de chacun des transistors à grille flottante des cellules mémoire $C_0$ à $C_7$ du premier mot de la ligne de mot $WI_2$.

Dans la deuxième colonne $Col_1$ de la mémoire, on a ainsi la zone de diffusion $LD_{1,1}$ qui forme la source $S_0,...$ $S_7$ de chacun des transistors à grille flottante des cellules mémoire $C_0$ à $C_7$ du deuxième mot de la ligne de mot $WI_1$ et la zone de diffusion $LD_{2,1}$ qui forme la source $S_0, ...$ $S_7$ de chacun des transistors à grille flottante des cellules mémoire $C_0$ à $C_7$ du deuxième mot de la ligne de mot $WI_2$.

Chacune de ces zones de diffusion forme aussi une ligne de diffusion dans une direction perpendiculaire aux sources. Chaque ligne de diffusion est réalisée jusqu'à l'endroit d'un contact respectif permettant sa connexion à une ligne métallique de source de la colonne associée, perpendiculaire. Le contact et la ligne de source sont réalisés en dehors de la zone d'implémentation des cellules mémoire de la colonne considérée. Dans l'exemple, aux lignes de diffusion $LD_{1,0}$, $LD_{1,1}$, correspondent respectivement les contacts P1, P2, sur la ligne de source en métal $LSo$ de la colonne $Col_0$ et aux lignes de diffusion $LD_{2,0}$, $LD_{2,1}$, correspondent respectivement les contacts P3, P4, sur la ligne de source en métal $LS_1$ de la colonne $Col_1$.

Selon cette implémentation, deux colonnes successives sont séparées entre elles par une ligne de source en métal.

Avec une telle implémentation, on perd du courant dans le chemin de connexion des sources au transistor de mise à la masse. En effet, les zones de diffusions sont résistives, induisant une perte de courant non négligeable, fonction de la longueur. Cette perte de courant est plus ou moins importante pour chaque cellule au sein d'un même mot. Si on reprend la figure 2a, on voit que, dans cet exemple, la cellule $C_7$ d'un mot est connectée à la ligne de source par une longueur de diffusion plus faible que la cellule $C_0$ du même mot. Aussi, la perte de courant dans la cellule $C_7$ est plus faible que dans la cellule $C_0$. En d'autres termes, la perte de courant dans une cellule d'un mot, due à la longueur de diffusion pour connecter la source de cette cellule d'un mot à la ligne de source correspondante est fonction de son rang dans ce mot.

Cette perte de courant est très gênante, plus particulièrement dans le mode d'accès en lecture par mot.

Rappelons que les cellules mémoire EEPROM, vierges en sortie de fabrication, peuvent être ensuite électriquement programmées, ce qui abaisse la tension de seuil de leur transistor à grille flottante, ou électriquement effacées, ce qui augmente cette tension de seuil.

Si on lit les cellules mémoire dans des conditions de polarisation en tension telles qu'une cellule vierge serait passante, il s'ensuit qu'en lecture, une cellule effacée ne conduit pas et une cellule programmée conduit.

Le principe de lecture des cellules mémoire repose sur la conversion courant/tension. Un amplificateur différentiel est ainsi prévu pour chaque bit du mot à lire, recevant en entrée le courant issu de la cellule sélectionnée en lecture et un courant de référence. Ce courant de référence est généralement fourni par une cellule mémoire de référence, vierge. Les conditions de polarisation en lecture sont telles que la cellule de référence vierge conduise, une cellule dans l'état programmée conduisant un plus fort courant tandis qu'une cellule effacée ne conduit pas.

Dans un exemple numérique, on aura comme valeurs typiques de courants, sous 5 volts de tension d'alimentation :

$I_p$=50 microampères (cellule programmée);
$I_v$=25 microampères (cellule vierge); et
$I_e$=0 (cellule effacée).

Si on considère le cas où les cellules mémoire $C_0,...C_7$ d'un mot sont toutes programmées, soumises aux mêmes conditions de polarisation en lecture, elles devraient en théorie passer toutes le même courant. Mais en raison du chemin résistif différent dans chaque cellule entre la source et le transistor de mise à la masse, on a un courant différent dans chaque cellule : le plus fort dans la cellule la plus proche géographiquement de la ligne de source, C, dans l'exemple, et le plus faible dans la cellule la plus éloignée, $C_0$ dans l'exemple.

Sur la figure 2b, on a représenté pour le premier mot de la ligne de mot $WI_1$, les résistances équivalentes R0, R1 et R2 de la zone de diffusion : R0, pour la partie de la diffusion entre le contact P1 et la source de la cellule la plus proche, $C_7$ dans l'exemple ; R1, pour chaque partie de la diffusion réalisant une source proprement dite d'une cellule mémoire ; R2, pour les parties de diffusion entre deux sources consécutives.

Si on considère que les cellules $C_0$ à $C_7$ sont dans un état identique, toutes passantes (vierges ou programmées), on calcule facilement le courant dans chaque cellule. En posant a=R2/R1 et i0 le courant passant dans la cellule $C_0$, on a :

$$i1=i0 + a.i0$$

$$i2=i0 + (3a + a^2).i0$$

$$i3=i0 + (6a + 5a^2 + a^3).i0$$

$$i4=i0 + (10a + 15a^2 + 7a^{3+} a^4).i0$$

$$i5=i0 + (15a + 35a^2 + 28a^3 + 9a^4 + a^5).i0$$

$$i6=i0 + (21a + 70a^2 + 84a^3 + 45a^4 + 11a^5 + a^6).i0$$

$$i7=i0 + (28a + 126a^2 + 210a^3 + 165a^4 + 66a^5 + 13a^6 + a^7).i0$$

Ainsi, l'écart extrême en courant est donné par :

$$\Delta I=i7-i0=(28a + 126a^2 + 210a^3 + 165a^4 + 66a^5 + 13a^6 + a^7)i0$$

avec $a<<1$.

Comme le courant dans des cellules $C_0,..C_7$ dans le même état (programmé par exemple) n'est pas identique, le temps d'établissement de chacun des bits d'un mot à lire n'est pas le même, ce qui dégrade le temps d'accès en lecture de la mémoire et peut rendre impossible une lecture en opérationnel. En outre, à basse tension d'alimentation, ces courants sont plus faibles. L'écart entre leurs valeurs typiques devient aussi plus faible. Par exemple, $I_p$ peut descendre en valeur typique à 20 microampères et $I_v$ à 10 microampères. Selon la position du bit dans le mot à lire, le courant d'une cellule programmée peut devenir trop proche du courant de référence, conduisant à une lecture erronée.

Pour pallier ce problème de variation du courant de programmation entre les cellules d'un mot à lire, dû à la résistivité de la ligne de diffusion, on a proposé dans l'art antérieur d'utiliser une architecture à double mot. L'idée à la base de cette solution est d'augmenter la valeur moyenne (ou typique) du courant de programmation. Ainsi, les variations ont-elles un effet moindre sur la lecture : fiabilité et temps d'accès. Le principe général est le suivant : lorsque l'on sélectionne un mot en lecture, on sélectionne automatiquement un deuxième mot, de manière à récupérer sur chaque ligne de bit, deux fois le courant d'une cellule. Ainsi, on augmente la différence entre état programmé et effacé, par rapport à la référence, permettant de fiabiliser la lecture différentielle. La mise en oeuvre de cette solution est particulièrement simple, pour les mémoires huit bits. En effet, on utilise habituellement le plan mémoire des mémoires 16 bits dans lequel on invalide un demi-plan, pour réaliser les mémoires huit bits. Pour mettre en oeuvre la solution de l'état de la technique, il suffit de valider le deuxième demi-plan en mode de lecture par mot et de modifier le décodeur pour réaliser la sélection automatique d'un mot dans le deuxième demi-plan, lorsqu'un mot est accédé en lecture dans le premier. Il faut en outre prévoir que les cellules du deuxième demi-plan sont toutes dans le même état, soit effacées, soit programmées, soit vierges.

Si on ne considère que des cellules programmées, au niveau de chaque ligne de bit, on récupère deux fois le courant d'une cellule, soit :

$$I(B0)=2i0$$

$$I(B1)=2i1=2i0 + (2a)i0$$

$$I(B2)=2i2=2i0 + (6a + 2a^2)i0$$

$$I(B3)=2i3=2i0 + (12a + 10a^2 + 2a^3)i0$$

$$I(B4)=2i4=2i0 + (20a + 30a^2 + 14a^3 + 2a^4)i0$$

$$I(B5)=2i5=2i0 + (30a + 70a^2 + 56a^3 + 18a^4 + 2a^5)i0$$

$$I(B6)=2i6=2i0 + (42a + 140a^2 + 168a^3 + 90a^4 + 22a^5 +$$

$$2a^6)i0$$

$$I(B7)=2i7=2i0 + (56a + 252a^2 + 420a^3 + 330a^4 + 132a^5 +$$

$$26a^6 + 2a^7)io.$$

Mais l'amplitude de la variation de courant est elle aussi doublée : $I(B7)-I(B0)= 56a + 252a^2 + 420a^3 + 330a^4 + 132a^5 + 26a^6 + 2a^7 = 2\Delta I$.

En théorie, si le mot supplémentaire automatiquement sélectionné en lecture contient des cellules programmées, on pourrait obtenir les courants de lecture suivants : $I_p$=100 microampères, sous 5 volts de tension d'alimentation; $I_p$=50 microampères, sous 2,5 volts de tension d'alimentation, $I_v$ étant inchangé et $I_e$ toujours égal à 0.

Cependant, en pratique, l'augmentation du courant est limitée par le transistor de mise à la masse, surtout à basse tension d'alimentation. En pratique, on ne double pas le courant passant dans les cellules, on l'augmente seulement un peu, si bien que cette solution s'avère insuffisante.

Tout ce qui a été expliqué en relation à une mémoire EEPROM s'applique aussi bien à une mémoire de type flash EPROM dont l'architecture comprend des blocs de cellules mémoire à ligne de source commune et plus généralement à une mémoire non volatile de type électriquement effaçable et programmable.

L'invention a ainsi pour objet une architecture d'une mémoire non volatile électriquement effaçable et programmable dans laquelle la lecture de mots est améliorée.

Dans l'état de la technique, on propose d'augmenter la valeur moyenne du courant de lecture des bits du mot à lire. Ainsi l'écart maximal entre les courants de lecture ne change pas ou peu. C'est l'écart avec le courant de référence qui est augmenté.

Dans l'invention, on propose un moyen pour réduire l'amplitude de variation des courants.

L'invention a ainsi pour objet une architecture d'une mémoire non volatile électriquement effaçable et programable, organisée par colonne de mots de n cellules mémoire, consistant pour chaque colonne à avoir :

- pour chaque mot, une ligne de diffusion pour connecter des sources des cellules mémoire à un transistor de mise à la masse par une ligne de source ou métal,
- un premier groupe de lignes de mots et un deuxième groupe de lignes de mot, le deuxième groupe étant tel que dans chaque colonne, l'accès en lecture d'un mot déterminé dans le premier groupe entraîne la sélection simultanée d'un mot correspondant dans le deuxième groupe,
- n lignes de bit de rang 0 à n-1, les n cellules de rang 0 à n-1 des mots du premier groupe étant chacune connectée à la ligne de bit de même rang.

Selon l'invention, cette architecture comprend des moyens d'implémentation de la connexion des n cellules de rang 0 à n-1 des mots du deuxième groupe chacune à une des n lignes de bit de la colonne, ces dits moyens étant tels que la longueur de connexion en diffusion à une ligne de source en métal des cellules d'un même rang des mots du deuxième groupe qui sont connectées à la ligne de bit de rang i corresponde à la longueur de connexion en diffusion à une ligne de source en métal des cellules de rang n-1-i des mots du premier groupe.

Dans une première variante, les moyens d'implémentation de la connexion comprennent une même ligne de bit par colonne pour les cellules de même rang des mots des premier et deuxième groupes et deux lignes de source en métal, une pour chacun des groupes, placées de part et d'autre de la zone d'implémentation de la colonne, les lignes de diffusion des mots de chaque groupe étant connectées à la ligne de source correspondante.

Dans une deuxième variante, les moyens d'implémentation de la connexion comprennent une ligne de source en métal pour chaque colonne placée en dehors de la zone d'implémentation de la colonne pour connecter les lignes de diffusion des mots des deux groupes à un transistor de mise à la masse, n lignes de bit de rang 0 à n-1 par groupe, les n lignes de bit d'un groupe étant chacune connectée aux cellules de même rang dans ce groupe, et un multiplexeur placé entre les deux groupes, pour connecter chacune des n lignes de bit de rang 0 à n-1 du premier groupe à la ligne de bit de rang n-1-i dans l'autre groupe.

En pratique, les premier et deuxième groupes correspondent généralement chacun à un demi-plan de la mémoire.

D'autres caractéristiques et avantages de l'invention sont détaillés dans la description suivante, faite à titre indicatif et non limitatif et en référence aux dessins annexés dans lesquels :

- la figure 1 déjà décrite représente un exemple d'architecture de mémoire EEPROM à accès par mot de l'état de la technique ;
- les figures 2a et 2b déjà décrites sont l'une le schéma d'implantation des sources et ligne de sources d'un mot de la mémoire de la figure 1, et l'autre l'équivalent électrique ;
- la figure 3 représente un exemple d'architecture mémoire selon un premier exemple de mise en oeuvre de l'invention ;
- la figure 4 représente un schéma d'implémentation de la mémoire correspondant à l'architecture de la figure 3 ;
- la figure 5 représente une architecture selon un deuxième exemple de mise en oeuvre de l'invention ; et
- la figure 6 représente schématiquement le principe de la deuxième variante.

L'invention va être décrite dans une application à une mémoire EEPROM, mais s'applique plus généralement à une mémoire non volatile électriquement effaçable et programmable.

Dans les figures, les mêmes éléments sont désignés par les mêmes références. Dans ces figures, la mémoire est organisée par colonnes de mots et comprend un premier groupe de lignes de mots et un deuxième groupe de lignes de mots, le deuxième groupe étant réservé à un mode d'accès en lecture par mots du premier groupe, tel que l'accès en lecture à un mot déterminé du premier groupe entraîne la sélection simultanée dans la même colonne d'un mot correspondant dans le deuxième groupe. De telles mémoires sont connues de l'homme du métier. Les principes détaillés d'implémentation ne seront donc pas détaillés. Dans la suite, on considère que chaque groupe forme un demi-plan de la mémoire, ce qui est le cas le plus simple et le plus courant.

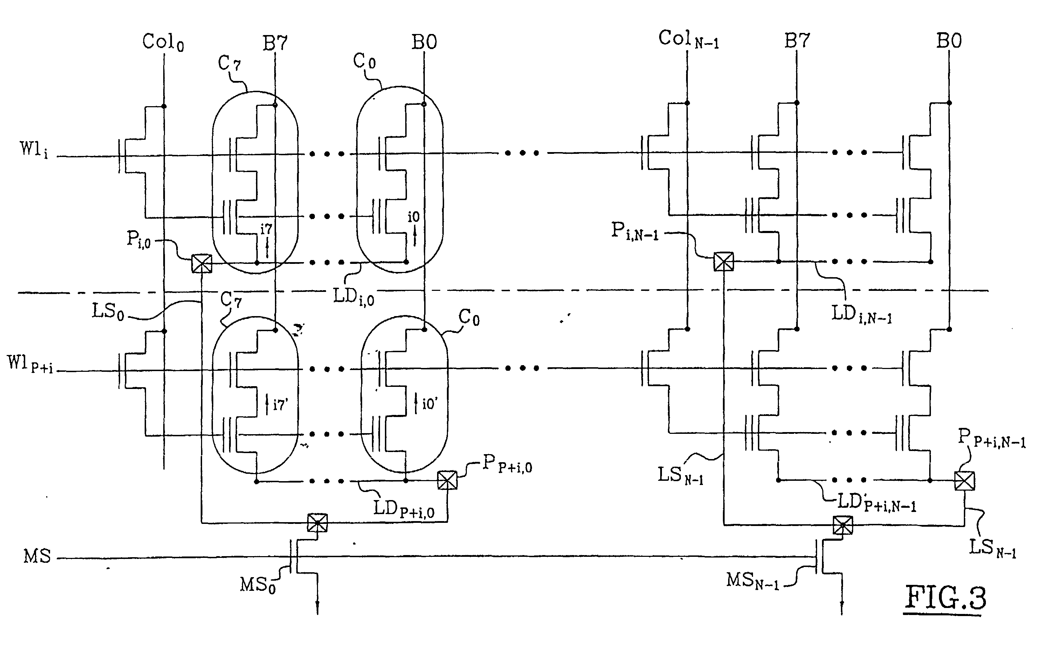

La figure 3 représente une première variante de mise en oeuvre de l'invention.

Dans cette variante, l'architecture mémoire consiste d'une manière générale à avoir pour chaque colonne mémoire, deux lignes de source en métal, une pour chaque groupe (demi-plan), situées de part et d'autre de la zone d'implémentation de la colonne, la ligne de diffusion de chaque mot d'un groupe étant connectée à la ligne de source correspondante.

De façon plus détaillée, la mémoire dont l'architecture est représentée sur la figure 3 comprend N colonnes mémoire $Col_0$ à $Col_{N-1}$ de huit lignes de bit B0 à B7 chacune.

Le plan mémoire est formé de deux demi-plans. Le premier demi-plan comprend p lignes de mot $Wl_0$ à $Wl_{p-1}$. Il contient les mots mémoire réellement disponibles pour l'application. Le deuxième demi-plan comprend p lignes de mot $Wl_p$ à $Wl_{2p-1}$. Il contient les mots mémoire utilisés selon l'invention pour le mode d'accès en lecture par mot.

On s'intéresse plus particulièrement à la première colonne. Elle contient p mots mémoire dans le premier demi-plan et p mots mémoire dans le deuxième.

Selon le principe utilisé dans l'invention, lorsqu'un mot est accédé en lecture, le décodeur (non représenté) sélectionne la ligne de mot correspondante dans le premier demi-plan et simultanément, une ligne de mot correspondante dans le deuxième demi-plan. Dans un exemple particulièrement simple de décodage, les lignes de mot de rang i, $Wl_i$, et de rang p+i, $Wl_{p+i}$, sont ainsi simultanément sélectionnées en lecture.

Le premier demi-plan est implémenté comme dans l'état de la technique. Chaque mot mémoire du premier demi-plan, par exemple le premier mot mémoire de la ligne de mot $Wl_i$, a une ligne de diffusion $LD_{1,0}$ pour réaliser les sources des cellules mémoire $C_0$ à $C_7$ et pour assurer la connexion à un contact $P_{i,0}$ sur une ligne de source $LS_0$ en métal. Ce contact est réalisé sur un côté, à l'extérieur de la zone d'implémentation de la colonne de cellules mémoire. Dans l'exemple représenté, la ligne de source et ses contacts sont situés à gauche de la zone d'implémentation de la colonne mémoire. Cette ligne de source en métal est connectée au drain du transistor de mise à la masse associé, $MS_0$ dans la source.

Le deuxième demi-plan est implémenté comme le premier, à l'exception de la connexion de la ligne de diffusion des sources à un contact sur une ligne de source en métal associée. Cette deuxième ligne de source est située à l'opposé de la première, par rapport à la zone d'implémentation de la colonne. Cette deuxième ligne de source en métal est connectée au drain du même transistor de mise à la masse associé à la colonne considérée. Ainsi, si on considère le premier mot de la ligne de mot $Wl_{p+i}$, sa ligne de diffusion $LD_{p+i,0}$ est connectée à un contact $P_{p+i,0}$ sur une ligne de source en métal LSo' située à l'extérieur de la zone d'implémentation de la colonne mémoire, du côté opposé à la ligne de source du premier demi-plan, c'est-à-dire, dans l'exemple de la figure 3, à droite de la zone d'implémentation de la colonne mémoire.

De cette façon, chacun des mots du premier demi-plan est tel que la cellule $C_7$ est la plus proche du contact de ligne de source et la cellule $C_0$, la plus éloignée, tandis que dans le deuxième demi-plan, c'est le contraire : la cellule $C_7$ est la plus éloignée et la cellule $C_0$ est la plus proche.

Si on appelle i7 et i0 le courant de lecture passant respectivement dans les cellules $C_7$ et $C_0$ d'un mot du premier demi-plan et i7' et i0' le courant de lecture passant dans les cellules $C_7$ et $C_0$ du mot correspondant sélectionné simultanément en lecture dans le deuxième demi-plan, on a idéalement : i0'=i7 et i7'=i0, si la symétrie est parfaite.

En lecture par mot, on retrouve en théorie sur la ligne de bit B7 concernée un courant égal à la somme des courants passants dans les deux cellules concernées, soit I(B7) = i7+i7'=i7+i0.

De même, sur la ligne de bit B0 concernée, on retrouve un courant égal à la somme des courants passants dans les deux cellules concernées, soit I(B0)=i0+i0'= i0+ i7.

Ainsi, les courants dans les deux lignes de bit B7 et B0 sont égaux.

De même, les courants dans les deux lignes de bit B6 et B1 sont égaux ; les courants dans les deux lignes de bit B5 et B2 sont égaux ; les courants dans les deux lignes de bit B4 et B3 sont égaux.

En outre, on montre que l'amplitude de la variation de courant est inférieure à l'état de la technique.

Avec a=R2/R1 (a<<1) et i0 le courant passant dans la cellule Codes mots du premier demi-plan, on a :

$$I(B0)=I(B7)=2i0+(28a + 126a^2 + 210a^3 + 165a^4 + 66a^5 +$$

$$13a^6 + a^7)i0$$

$$I(B1) = I(B6) = 2i0 + (22a + 70a^2 + 84a^3 + 45a^4 + 11a^5 + a^6)i0$$

$$I(B2)=I(B5)= 2i0+(18a + 38a^2 + 28a^3 + 9a^4 + a^5)i0$$

$$I(B3)=I(B4)= 2i0 +(16a + 20a^2 + 8a^3 + a^4)i0$$

L'écart maximal entre les courants est alors donné par I(B0)-I(B3)=I(B7)-I(B4)= $(12a + 106a + 202a^3 + 164a^4 + 66a^5 + 13a^6 + a^7)i0$.

Dans l'état de la technique, avec la sélection simultanée de deux mots, cette variation était égale à 2ΔI= $(56a + 252a^2 + 420a^3 + 330a^4 + 132a^5 + 26a^6 + 2a^7)i0$.

Ainsi, avec l'invention, on réduit d'un rapport supérieur à 4, dans le premier ordre (a), la variation extrême de courant.

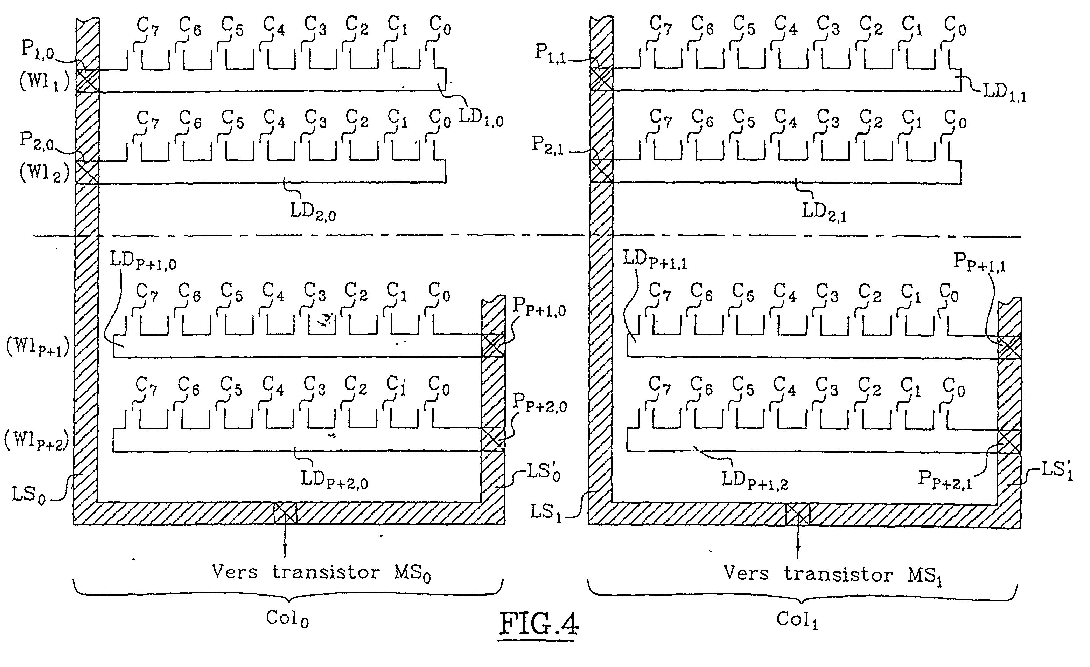

La figure 4 montre le schéma correspondant de l'implémentation partielle de cette architecture. Elle montre pour chacune des deux premières colonnes mémoire $Col_0$ et $Col_1$, la réalisation des deux lignes de source en métal, une pour chaque demi-plan, situées de par et d'autre de la zone d'implémentation de la colonne mémoire.

Cette implémentation augmente l'espace physique nécessaire, puisqu'elle nécessite deux lignes de source en métal par colonne.

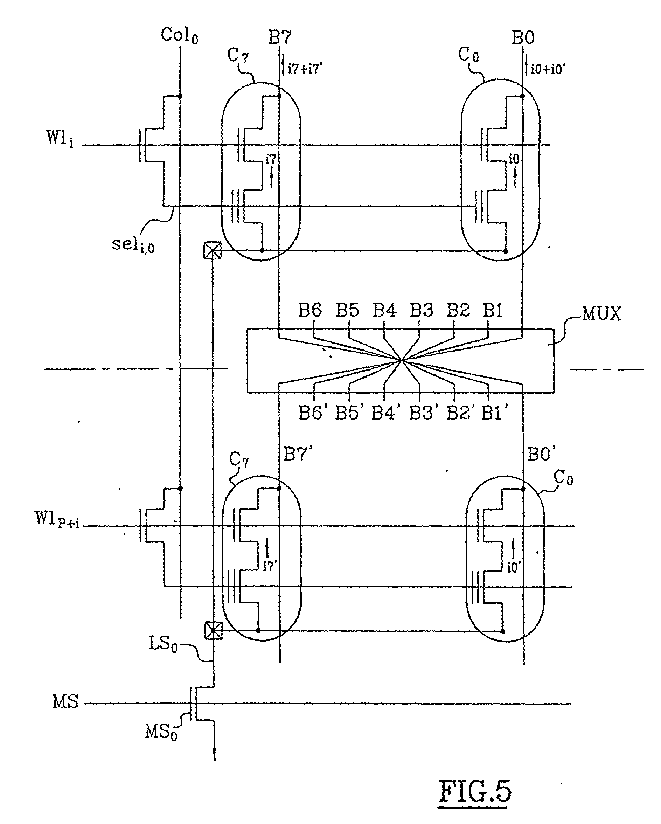

La figure 5 représente une deuxième variante de mise en oeuvre de l'invention. Dans cette variante, au lieu d'avoir deux lignes de source en métal, une par demi-plan, de part et d'autre de la zone d'implémentation de la colonne mémoire à laquelle elles sont associées, on a une seule ligne de source en métal.

Dans cette architecture, on prévoit pour chaque colonne, n lignes de bits par demi-plan : B0 à B7 pour le premier, B0' à B7' pour le deuxième.

Dans chaque demi-plan, les n lignes de bit de chaque colonne, de rang 0 à n-1, sont connectées chacune aux cellules de même rang.

Un multiplexeur MUX est prévu entre les deux demi-plans pour connecter chacune des lignes de bit du premier demi-plan à une ligne de bit du deuxième demi-plan.

En mode d'accès en lecture par mot, le multiplexeur selon l'invention connecte pour chaque colonne, la ligne de bit de rang i du premier demi-plan à la ligne de bit de rang n-l-i du deuxième demi-plan, pour i égal 0 à n-1.

Dans l'exemple représenté sur la figure 5, on a ainsi la ligne de bit B0, connectée avec la ligne de bit B7', ... et ainsi de suite jusqu'à la ligne de bit B7, connectée avec la ligne de bit B0'.

Le résultat obtenu en terme de courant est identique à celui de la première variante.

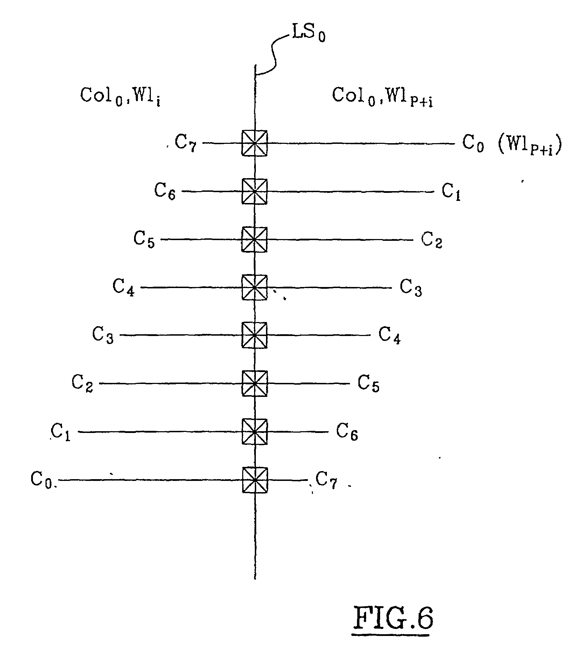

La figure 6 montre schématiquement le principe d'implémentation selon cette deuxième variante. Pour chaque colonne, $Col_0$ dans l'exemple, on fait ainsi correspondre la cellule $C_7$ de la ligne de mot $Wl_1$ du premier demi-plan, à

la cellule $C_0$ de la ligne de mot $WI_{p+i}$ du deuxième demi-plan.

En dehors du mode d'accès par mots, on peut prévoir, par défaut, soit que les lignes de bit du deuxième demi-plan ne sont pas connectées aux lignes de bit du premier demi-plan, soit qu'elles sont connectées aux lignes de bit de même rang, soit qu'elles sont toujours connectées selon le schéma du mode d'accès en lecture par mot.

L'intérêt de cette deuxième variante réside dans l'implémentation des connexions ligne de diffusion/ligne de source, identique dans les deux demi-plans, le multiplexeur étant un élément logique ne prenant pas beaucoup de place.

Dans les deux variantes, on a ainsi des moyens d'implémentation particuliers pour la connexion des n cellules de rang 0 à n-1 des mots du deuxième groupe chacune à une des n lignes de bit B0 à B7 du premier groupe de la colonne. Ces moyens sont tels que la longueur de connexion en diffusion à une ligne de source des cellules d'un même rang des mots du deuxième groupe qui sont connectées à la ligne de bit de rang i corresponde à la longueur de connexion en diffusion à une ligne de source des cellules de rang n-1-i des mots du premier groupe.

On notera que l'architecture mémoire selon l'invention peut couvrir par extension l'implémentation des cellules de référence. En mode d'accès en lecture par mots, on peut en effet prévoir qu'un mot de cellules de référence est sélectionné dans le premier groupe simultanément avec un autre mot dans le deuxième groupe. L'architecture selon l'invention permet alors d'améliorer la stabilité du courant de référence de lecture.

Enfin, on remarquera que dans la première variante les lignes de source métal du premier groupe sont plus longues que celles du deuxième groupe, mais les pertes de courant induites par cette différence sont négligeables.

**Revendications**

1. Architecture d'une mémoire non volatile électriquement effaçable et programmable organisée par colonnes de mots ($Col_0$) de n cellules mémoire ($C_0,...,C_7$), consistant pour chaque colonne à avoir :

   - pour chaque mot, une ligne de diffusion ($LD_0$) pour connecter des sources des cellules mémoire à un transistor de mise à la masse ($MS_0$) par une ligne de source en métal,
   - un premier groupe de lignes de mots et un deuxième groupe de lignes de mot, le deuxième groupe étant tel que dans chaque colonne, l'accès en lecture d'un mot déterminé dans le premier groupe entraîne la sélection simultanée d'un mot correspondant dans le deuxième groupe,
   - n lignes de bit de rang 0 à n-1 (B0 à B7), les n cellules de rang 0 à n-1 des mots du premier groupe étant chacune connectée à la ligne de bit de même rang,

   **caractérisée en ce qu'**elle comprend des moyens d'implémentation de la connexion des n cellules de rang 0 à n-1 des mots du deuxième groupe chacune à une des n lignes de bit de la colonne, ces dits moyens étant tels que la longueur de connexion en diffusion à une ligne de source en métal des cellules d'un même rang des mots du deuxième groupe qui sont connectées à la ligne de bit de rang i corresponde à la longueur de connexion en diffusion à une ligne de source en métal des cellules de rang n-1-i des mots du premier groupe.

2. Architecture mémoire selon la revendication 1, **caractérisé en ce que** les moyens d'implémentation de la connexion comprennent une même ligne de bit par colonne pour les cellules de même rang des mots des premier et deuxième groupes (B0 à B7) et deux lignes de source en métal ($LS_0$ et $LS_0'$), une pour chacun des groupes, placées de part et d'autre de la zone d'implémentation de la colonne, les lignes de diffusion des mots de chaque groupe étant connectées à la ligne de source en métal correspondante.

3. Architecture mémoire selon la revendication 1, **caractérisé en ce que** les moyens d'implémentation de la connexion comprennent une ligne de source en métal ($LS_0$) pour chaque colonne, placée en dehors de la zone d'implémentation de la colonne, pour connecter les lignes de diffusion des mots des deux groupes à un transistor de mise à la masse, et n lignes de bit de rang 0 à n-1 par groupe (B0 à B7 et B0' à B7'), les n lignes de bit d'un groupe étant chacune connectée aux cellules de même rang dans ce groupe, et un multiplexeur (MUX) placé entre les deux groupes, pour connecter chacune des n lignes de bit de rang i du premier groupe à la ligne de bit de rang n-l-i dans l'autre groupe.

4. Architecture mémoire selon l'une des revendications précédentes, les colonnes de mots de cellules mémoire comprenant au moins une colonne de cellules de référence de lecture.

5. Circuit intégré comprenant une mémoire non volatile électriquement effaçable et programmable ayant une architecture selon l'une quelconque des revendications 1 à 4.

**6.** Circuit intégré selon la revendication 5, **caractérisé en ce que** les cellules mémoire du deuxième groupe sont toutes dans le même état.

**7.** Circuit intégré selon la revendication 5 ou 6, **caractérisé en ce que** le premier et le deuxième groupe forment chacun un demi-plan de la mémoire.

**8.** Circuit intégré selon l'une des revendications 5 à 7, **caractérisé en ce que** la mémoire est de type EEPROM.

**Claims**

**1.** Architecture for an electrically erasable and programmable non-volatile memory organised in columns of words ($Col_0$) of n memory cells ($C_0$, ..., $C_7$), consisting, for each column, of having:

- for each word, a diffusion line ($LD_0$) for connecting sources of memory cells to an earthing transistor ($MS_0$) through a metal source line,

- a first group of word lines and a second group of word lines, the second group being such that, in each column, access in read mode to a given word in the first group entails the simultaneous selection of a corresponding word in the second group,

- n bit lines of rank 0 to n-1 (B0 to B7), the n cells of rank 0 to n-1 of the words of the first group each being connected to the bit line of the same rank,

**characterised in that** it comprises means of implementing the connection of each of the n cells of rank 0 to n-1 of the words of the second group to one of the n bit lines of the column, these said means being such that the length of diffusion connection to a metal source line of the cells of the same rank of the words of the second group which are connected to the bit line of rank i corresponds to the length of diffusion connection to a metal source line of the cells of rank n-1-i of the words of the first group.

**2.** Memory architecture according to Claim 1, **characterised in that** the means of implementing the connection comprise the same bit line per column for the cells of the same rank of the words of the first and second groups (B0 to B7) and two metal source lines ($LS_0$ and $LS_0'$), one for each of the groups, placed on each side of the column implementation zone, the diffusion lines of the words of each group being connected to the corresponding metal source line.

**3.** Memory architecture according to Claim 1, **characterised in that** the connection implementation means comprise a metal source line ($LS_0$) for each column, placed outside the column implementation zone, for connecting the diffusion lines of the words of the two groups to an earthing transistor, and n bit lines of rank 0 to n-1 per group (B0 to B7 and B0' to B7'), the n bit lines of a group each being connected to the cells of the same rank in this group, and a multiplexer (MUX) placed between the two groups, for connecting each of the n bit lines of rank i in the first group to the bit line of rank n-l-i in the other group.

**4.** Memory architecture according to one of the preceding claims, the columns of words of memory cells comprising at least one column of reference reading cells.

**5.** Integrated circuit comprising an electrically erasable and programmable non-volatile memory having an architecture according to any one of Claims 1 to 4.

**6.** Integrated circuit according to Claim 5, **characterised in that** the memory cells of the second group are all in the same state.

**7.** Integrated circuit according to Claim 5 or 6, **characterised in that** the first and second group each form a half-plane of the memory.

**8.** Integrated circuit according to one of Claims 5 to 7, **characterised in that** the memory is of the EEPROM type.

**Patentansprüche**

1. Aufbau eines nicht-flüchtigen, elektrisch löschbaren und programmierbaren Speichers, der in Wortspalten ($Col_0$) mit n Speicherzellen ($C_0$..., $C_7$) unterteilt ist, bei dem bei jeder Spalte:

   für jedes Wort eine Diffusionsleitung ($LD_0$) zum Verbinden von Source-Anschlüssen von Speicherzellen mit einem Transistor ($MS_0$) für das Erden über eine Source-Metallleitung vorgesehen ist,
   eine erste Gruppe von Wortleitungen und eine zweite Gruppe von Wortleitungen vorgesehen ist, wobei die zweite Gruppe derart ausgelegt ist, dass der Lesezugriff auf ein vorgegebenes Wort in der ersten Gruppe die simultane Auswahl eines entsprechenden Wortes in der zweiten Gruppe zur Folge hat,
   n Bit-Leitungen mit Rang 0 bis n-1 (B0 bis B7) vorgesehen sind, wobei die n Zellen vom Rang 0 bis n-1 von Worten der ersten Gruppe jeweils mit der Bit-Leitung gleichen Ranges verbunden sind,

   **gekennzeichnet durch**,
   Vorrichtungen zum Implementieren der Verbindung von n Zellen vom Rang 0 bis n-1 von Worten der zweiten Gruppe jeweils mit einer von n Bit-Leitungen der Spalte, wobei diese Vorrichtungen so ausgelegt sind, dass die Länge der Diffusionsverbindung mit einer Source-Metallleitung bei Zellen eines gleichen Wortranges der zweiten Gruppe, die mit der Bit-Leitung vom Rang i verbunden sind, der Länge der Diffusionsverbindung mit einer Source-Metallleitung von Zellen vom Rang n-1-i von Worten der ersten Gruppe entspricht.

2. Speicheraufbau nach Anspruch 1,
   **dadurch gekennzeichnet, dass**
   die Vorrichtungen für die Implementierung der Verbindung eine gleiche Bit-Leitung pro Spalte für die Zellen mit dem gleichen Wortrang aus der ersten und zweiten Gruppe (B0 bis B7) sowie zwei Source-Metallleitungen ($LS_0$ und $LS_0'$) mit jeweils einer für jede der Gruppen umfasst, die auf beiden Seiten des Implementierungsbereichs der Spalte angeordnet sind, wobei die Wort-Diffusionsleitungen jeder Gruppe mit der entsprechenden Source-Metallleitung verbunden sind.

3. Speicheraufbau nach Anspruch 1,
   **dadurch gekennzeichnet, dass**
   die Vorrichtungen zum Implementieren der Verbindung umfassen eine Source-Metallleitung ($LS_0$) für jede Spalte, die außerhalb des Implementierungsbereichs mit der Spalte angeordnet ist, um die Wort-Diffusionsleitungen von zwei Gruppen mit einem Erdungstransistor zu verbinden, und
   n Bit-Leitungen mit Rang 0 bis n-1 pro Gruppe (B0 bis B7 und B0' bis B7'), wobei die n Bit-Leitungen einer Gruppe jeweils mit Zellen gleichen Ranges in dieser Gruppe verbunden sind, und einen Multiplexer (MUX) zwischen den zwei Gruppen, um jede der n Bit-Leitungen vom Rang i in der ersten Gruppe mit der Bit-Leitung vom Rang n-l-i in der anderen Gruppe zu verbinden.

4. Speicheraufbau nach einem der vorangehenden Ansprüche, bei dem
   die Wortspalten von Speicherzellen wenigstens eine Spalte von Lese-Referenzzellen umfassen.

5. Integrierter Schaltkreis mit einem nicht-flüchtigen, elektrisch löschbaren und programmierbaren Speicher mit einem Aufbau nach einem der Ansprüche 1 bis 4.

6. Integrierter Schaltkreis nach Anspruch 5,
   **dadurch gekennzeichnet, dass**
   die Speicherzellen der zweiten Gruppe sich alle in demselben Zustand befinden.

7. Integrierter Schaltkreis nach Anspruch 5 oder 6,
   **dadurch gekennzeichnet, dass**
   die erste und die zweite Gruppe jeweils eine Halbebene des Speichers bilden.

8. Integrierter Schaltkreis nach einem der Ansprüche 5 bis 7,
   **dadurch gekennzeichnet, dass**
   der Speicher ein EEPROM-Speicher ist.

FIG.1

**FIG.2a**

**FIG.2b**

FIG.3

FIG.4

EP 1 085 518 B1

FIG.5

$LS_0$

$Col_0, Wl_i$                                $Col_0, Wl_{P+i}$

$C_7$ —⊠——————————————— $C_0$ $(Wl_{P+i})$

$C_6$ ———⊠————————— $C_1$

$C_5$ ————⊠————— $C_2$

$C_4$ —————⊠——— $C_3$

$C_3$ ——————⊠—— $C_4$

$C_2$ ————⊠————— $C_5$

$C_1$ ———⊠————————— $C_6$

$C_0$ ——⊠——————————————— $C_7$

## FIG.6